# EUROPEAN PATENT APPLICATION

(11) **EP 3 730 979 A1**
(43) Date of publication of application: **28.10.2020**
(21) Application number: 18892493.0
(22) Date of filing: 04.12.2018
(51) Int. Cl.: G02B 5/20, G02B 5/26, C09K 11/79, C09K 11/80, F21S 2/00, F21V 7/26, F21V 9/30, H01L 33/50, H01S 5/022, F21Y 115/30

(54) **LIGHT-EMITTING APPARATUS**

(30) Priority: 18.12.2017 JP 2017241754
(71) Applicant: Panasonic Intellectual Property Management Co., Ltd., Osaka-shi, Osaka 540-6207 (JP)
(72) Inventor: OSHIO, Shozo, Chuo-ku Osaka-shi, Osaka 540-6207 (JP); ABE, Takeshi, Chuo-ku Osaka-shi, Osaka 540-6207 (JP)
(74) Representative: Müller-Boré & Partner Patentanwälte PartG mbB
(86) International application number: PCT/JP2018/044494
(87) International publication number: WO 2019/124046

(57) **Abstract**

A light-emitting apparatus (100) includes: a first phosphor layer (1) including a first phosphor composed of an inorganic phosphor activated by Ce³⁺; and a second phosphor layer (2) including a second phosphor composed of an inorganic phosphor activated by Ce³⁺ and different from the first phosphor. The second phosphor layer is provided so as to be spaced apart from the first phosphor layer. The light-emitting apparatus further includes: an optical filter (3) provided between the first phosphor layer and the second phosphor layer; and an excitation source (6) that emits light that excites at least one of the first phosphor and the second phosphor. The second phosphor has light absorption characteristics of absorbing at least a part of first fluorescence (41) emitted by the first phosphor. The optical filter reflects at least a part of the first fluorescence emitted by the first phosphor, and allows passage of second fluorescence (42) emitted by the second phosphor.

## Description

### TECHNICAL FIELD

The present invention relates to a light-emitting apparatus. More specifically, the present invention relates to a light-emitting apparatus composed by combining a phosphor and a solid-state light emitting element, and particularly, a laser diode with each other.

### BACKGROUND ART

Heretofore, there has been known a light-emitting apparatus composed by combining a solid-state light emitting element and a wavelength converter including a phosphor with each other. As such a light-emitting apparatus as described above, for example, a white LED light source, a laser illuminator and a laser projector have been known.

In a light-emitting apparatus using laser light, a Ce³⁺-activated phosphor that emits fluorescence with ultrashort afterglow properties is preferably used in order to relieve saturation of a light output, which follows an increase of a power density of light that excites a phosphor. Then, a Ce³⁺-activated phosphor that emits green-series (blue-green or green) fluorescence and a Ce³⁺-activated phosphor that emits warm color-series (orange or red) fluorescence are used in combination, whereby illumination light with high color rendering properties can be achieved.

Moreover, heretofore, a light-emitting apparatus configured to increase light extraction efficiency by including a band-pass filter has also been known. In Patent Literature 1, a light-emitting apparatus is disclosed, which includes a substrate, a light emitting element disposed on the substrate, a phosphor-containing layer, a band-pass filter composed of a multilayer film including a plurality of dielectric layers.

### CITATION LIST

### PATENT LITERATURE

Patent Literature 1: Japanese Patent No. 6163754

### SUMMARY OF INVENTION

In general, the warm color-series Ce³⁺-activated phosphor has characteristics of efficiently absorbing blue to blue-green light components. Moreover, green-series light emitted by a green-series Ce³⁺-activated phosphor has a broad fluorescence spectrum shape. Therefore, in a light-emitting apparatus in which the warm color-series Ce³⁺-activated phosphor and the green-series Ce³⁺-activated phosphor are close to each other, a short wavelength-side light component (blue to blue green) emitted by the green-series Ce³⁺-activated phosphor is sometimes absorbed by the warm color-series Ce³⁺-activated phosphor. As a result, there has been a possibility that an intensity of the blue to the blue green may sometimes decrease to reduce color rendering properties of output light.

The present invention has been made in consideration of such a problem as described above, which is inherent in the prior art. It is an object of the present invention to provide a light-emitting apparatus capable of emitting output light with high color rendering properties even if a plurality of types of Ce³⁺-activated phosphors different in color tone are brought close to each other.

In order to solve the above-described problem, a light-emitting apparatus according to an aspect of the present invention includes: a first phosphor layer including a first phosphor composed of an inorganic phosphor activated by Ce³⁺; a second phosphor layer including a second phosphor composed of an inorganic phosphor activated by Ce³⁺ and different from the first phosphor, the second phosphor layer being provided so as to be spaced apart from the first phosphor layer; an optical filter provided between the first phosphor layer and the second phosphor layer; and an excitation source that emits light that excites at least one of the first phosphor and the second phosphor. The second phosphor has light absorption characteristics of absorbing at least a part of the first fluorescence emitted by the first phosphor. The optical filter reflects at least a part of the first fluorescence emitted by the first phosphor, and allows passage of second fluorescence emitted by the second phosphor.

### BRIEF DESCRIPTION OF DRAWINGS

[Fig. 1] FIG. 1 is a cross-sectional view schematically illustrating an example of a light-emitting apparatus according to this embodiment.
[Fig. 2] FIG. 2 is a cross-sectional view schematically illustrating another example of the light-emitting apparatus according to this embodiment.
[Fig. 3] FIG. 3 is electron microscope observation images showing phosphors used in an example. FIG. 3(a) shows a Y₃Al₂(AlO₄)₃:Ce³⁺ phosphor, and FIG. 3(b) shows a Lu₂CaMg₂(SiO₄)3:Ce³⁺ phosphor.
[Fig. 4] (a) in FIG. 4 is a fluorescence spectrum of Y₃Al₂(AlO₄)₃:Ce³⁺ that is a first phosphor. (b) in FIG. 4 is a fluorescence spectrum of Lu₂CaMg₂(SiO₄)3:Ce³⁺ that is a second phosphor. (b') in FIG. 4 is an absorption spectrum of Lu₂CaMg₂(SiO₄)₃:Ce³⁺.
[Fig. 5] FIG. 5 is a spectrum diagram illustrating light transmission characteristics of an optical interference filter used in the example.
[Fig. 6] FIG. 6 is a diagram illustrating fluorescence spectra before and after passing through the optical interference filter in Lu₂CaMg₂(SiO₄)3:Ce³⁺ that is the second phosphor.
[Fig. 7] FIG. 7 is a spectrum diagram illustrating an example of a spectral distribution of output light in a light-emitting apparatus according to the example.

### DESCRIPTION OF EMBODIMENTS

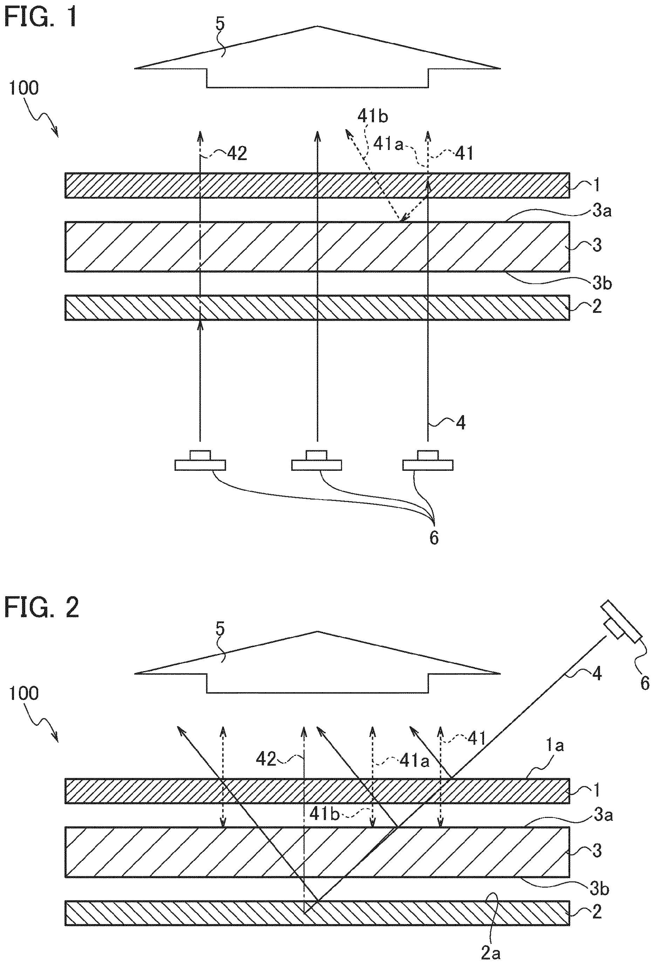

This embodiment will be described below with reference to the drawings. Note that any of embodiments to be described below illustrates a preferable specific example of this embodiment. Hence, numeric values, shapes, materials, constituents, arrangement positions and connection modes of the constituents, and the like, which are illustrated in the following embodiments, are merely examples, and are not intended to limit this embodiment. Note that FIG. 1 and FIG. 2 are schematic diagrams, and are not always strictly illustrated. Moreover, in FIG. 1 and FIG. 2, the same reference numerals are assigned to substantially the same constituents, and duplicate descriptions will be omitted or simplified.

First, a description will be given of a configuration of a light-emitting apparatus according to this embodiment with reference to FIG. 1 and FIG. 2. FIG. 1 is a schematic diagram of a light-emitting apparatus having a structure called a transmissive structure, and FIG. 2 is a schematic diagram of a light-emitting apparatus a structure called a reflective structure.

A light-emitting apparatus 100 of this embodiment includes a first phosphor layer 1 and a second phosphor layer 2, which are wavelength converters. Specifically, the light-emitting apparatus 100 includes: the first phosphor layer 1 including a first phosphor composed of an inorganic phosphor activated by Ce³⁺; and a second phosphor layer 2 including a second phosphor composed of an inorganic phosphor activated by Ce³⁺. Moreover, the first phosphor and the second phosphor are phosphors different from each other, and further, also have fluorescent color tones different from each other.

The light-emitting apparatus 100 further includes an optical filter 3 provided between the first phosphor layer 1 and the second phosphor layer 2. As illustrated in FIG. 1 and FIG. 2, the first phosphor layer 1 is disposed on a one-side surface 3a of the optical filter 3, and the second phosphor layer 2 is disposed on an other-side surface 3b located opposite with the surface 3a. The surface 3a of the optical filter 3 may be in contact with the first phosphor layer 1, or may be spaced apart therefrom. Moreover, the surface 3b of the optical filter 3 may be in contact with the second phosphor layer 2, or may be spaced apart therefrom.

As illustrated in FIG. 1, the transmissive-type light-emitting apparatus 100 has a feature to emit output light 5 in such a direction in which primary light 4 emitted from an excitation source 6 passes through the first phosphor layer 1 and the second phosphor layer 2. Meanwhile, as illustrated in FIG. 2, the reflective-type light-emitting apparatus 100 has a feature to emit the output light 5 in such a direction in which the primary light 4 is reflected by the first phosphor layer 1 and the second phosphor layer 2.

The first phosphor layer 1 is a wavelength converter including the first phosphor that emits at least first fluorescence 41. The first phosphor layer 1 is a wavelength converter composed by including a Ce³⁺-activated phosphor, and the Ce³⁺-activated phosphor emits fluorescence having a fluorescence peak, for example, within a wavelength range of 490 nm or more and less than 560 nm, preferably 500 nm or more and less than 550 nm.

The first phosphor layer 1 can be fabricated by sealing the first phosphor by a sealing material. Preferably, the sealing material is at least one of an organic material and an inorganic material, and particularly, at least one of a transparent (translucent) organic material and a transparent (translucent) inorganic material. As such a sealing material made of the organic material, for example, a transparent organic material such as a silicone resin is mentioned. As such a sealing material made of the inorganic material, for example, a transparent inorganic material such as low-melting-point glass is mentioned.

Moreover, as the first phosphor layer 1, a sintered body that is composed in such a manner that the first phosphor is sintered, and has a plurality of air gaps in the inside thereof. Moreover, as the first phosphor layer 1, there can be used a ceramic body composed in such a manner that the first phosphor is sintered, and does not have a plurality of air gaps in the inside thereof. The first phosphor layer 1 is the sintered body or the ceramic body, which is as described above, whereby it becomes easy to produce and handle the first phosphor layer 1, and accordingly, a wavelength converter suitable to industrial production is formed.

The second phosphor layer 2 is a wavelength converter including the second phosphor that emits second fluorescence 42 different from the first fluorescence 41. The second phosphor layer 2 is a wavelength converter composed by including a Ce³⁺-activated phosphor, and the Ce³⁺-activated phosphor emits fluorescence having a fluorescence peak, for example, within a wavelength range of 560 nm or more and less than 660 nm, preferably 580 nm or more and less than 650 nm. The second phosphor layer 2 can be fabricated by sealing the second phosphor by the above-mentioned sealing material similarly to the first phosphor layer 1. Moreover, as the second phosphor layer 2, a sintered body or a ceramic body, which is composed by sintering the second phosphor, can also be used.

Note that the second phosphor has light absorption characteristics of absorbing at least a part of a light component of the first fluorescence 41 emitted by the first phosphor.

A shape of the first phosphor layer 1 and the second phosphor layer 2 is not particularly limited. Preferably, the shape of the first phosphor layer 1 and the second phosphor layer 2 is a thin plate shape, and also preferably, is a disc shape or a rectangular plate shape. It becomes easy to produce and handle the first phosphor layer 1 and the second phosphor layer 2, which have such a shape as described above.

The optical filter 3 is a member that has wavelength dependency of a light transmittance. That is, the optical filter 3 is a member that allows passage of light in incident light, the light remaining within a specific wavelength range, and reflects or absorbs light remaining within the other wavelength range.

In FIG. 1 and FIG. 2, the primary light 4 is light emitted by the excitation source 6. Then, the primary light 4 is light that excites at least one of the first phosphor included in the first phosphor layer 1 and the second phosphor included in the second phosphor layer 2. Note that, preferably, the primary light 4 is light that excites both of the first phosphor and the second phosphor.

For example, the primary light 4 can be set to be at least a piece of light selected from the group consisting of a near ultraviolet ray, violet light and blue light. Note that the near ultraviolet ray is at least one selected from the group consisting of UV-C with a wavelength of 200 to 280 nm, UV-B with a wavelength of 280 to 315 nm, and UV-A with a wavelength of 315 to 380 nm. The violet light is visible light with a wavelength of 380 to 450 nm. The blue light is visible light with a wavelength of 450 to 495 nm.

The output light 5 is output light emitted by the light-emitting apparatus 100, and for example, is white light for use in illumination. Note that the output light 5 can also be mixed color light in which the primary light 4, the first fluorescence 41 composed by subjecting the primary light 4 to wavelength conversion by the first phosphor, and the second fluorescence 42 composed by subjecting the primary light 4 to wavelength conversion by the second phosphor are additively mixed with one another.

As described above, the light-emitting apparatus 100 according to this embodiment includes: the first phosphor layer 1; the second phosphor layer 2; the optical filter 3; and the excitation source 6 that emits the primary light 4 that excites at least one of the first phosphor layer 1 and the second phosphor layer 2. That is, the light-emitting apparatus 100 includes at least: the first phosphor that emits the first fluorescence 41; the second phosphor that emits the second fluorescence different in color tone from the fluorescence of the first phosphor; the optical filter 3; and the excitation source 6.

Then, the optical filter 3 has a function to reduce a light component of the first fluorescence 41 applied to the second phosphor though to allow passage of a light component of the second fluorescence 42. Moreover, preferably, the optical filter 3 has a function to allow passage of the primary light 4 emitted from the excitation source 6. Furthermore, the optical filter 3 is disposed so as to reduce the light component of the first fluorescence 41 applied to the second phosphor. That is, the optical filter 3 is provided between the first phosphor layer 1 and the second phosphor layer 2, and thereby makes it difficult for the first fluorescence 41 emitted from the first phosphor layer 1 to reach the second phosphor included in the second phosphor layer 2.

In order to emit the output light 5 from the light-emitting apparatus 100 as described above, first, the primary light 4 is applied from the first phosphor layer 1 side or the second phosphor layer 2 side by using the excitation source 6. Specifically, in the transmissive-type light-emitting apparatus 100 illustrated in FIG. 1, the primary light 4 is applied upward from the second phosphor layer 2 side. A part of the primary light 4 applied to the second phosphor layer 2 is absorbed to the second phosphor, and excites the second phosphor. Then, the excited second phosphor emits the second fluorescence 42 upward. The optical filter 3 can allow passage of the second fluorescence 42 and the primary light 4. Accordingly, the second fluorescence 42 and the primary light 4 that is not absorbed to the second phosphor pass through the optical filter 3, and reach the first phosphor layer 1.

A part of the primary light 4 that has reached the first phosphor layer 1 is absorbed to the first phosphor, and excites the first phosphor. Then, as illustrated in FIG. 1, the excited first phosphor emits the first fluorescence 41 upward and downward. Here, the optical filter 3 has a function to reflect the first fluorescence 41 though to allow passage of the second fluorescence 42 and the primary light 4. Therefore, the first fluorescence 41b emitted downward from the first phosphor is reflected by the surface 3a of the optical filter 3, and is emitted upward. Note that the second fluorescence 42 that has reached the first phosphor layer 1 is not absorbed in the first phosphor, and passes through the first phosphor layer 1.

Then, the first fluorescence 41a emitted upward from the first phosphor layer 1 and the first fluorescence 41b that is reflected by the optical filter 3 and has passed through the first phosphor layer 1, and the second fluorescence 42 and the primary light 4, which have passed through the optical filter 3 and the first phosphor layer 1, are subjected to additive color mixture. As a result, the output light 5 in which these light components are mixed with one another is emitted to the outside of the light-emitting apparatus 100.

Here, in a case where the optical filter 3 is not provided between the first phosphor layer 1 and the second phosphor layer 2, the first fluorescence 41b emitted downward from the first phosphor layer 1 reaches the second phosphor layer 2. As mentioned above, the second phosphor has characteristics of absorbing at least a part of the first fluorescence 41 emitted by the first phosphor. Accordingly, at least a part of the first fluorescence 41b that has reached the second phosphor is absorbed by the second phosphor. As a result, it becomes difficult for a fluorescence spectrum shape of the first fluorescence 41 to keep an original spectrum shape thereof, and color rendering properties of the obtained output light 5 decrease.

However, in the light-emitting apparatus 100 of this embodiment, the light component of the first fluorescence 41 is suppressed from being absorbed to the second phosphor by the function of the optical filter 3. Therefore, an influence given to the first fluorescence 41 by the light absorption characteristics of the second phosphor, which have wavelength dependency, is relieved. As a result, it becomes easy for the fluorescence spectrum shape of the first fluorescence 41 to keep the original shape thereof, thus making it possible to emit the output light 5 that serves as illumination light with high color rendering properties.

In order to emit the output light 5 from the reflective-type light-emitting apparatus 100 illustrated in FIG. 2, first, the primary light 4 is applied downward from the first phosphor layer 1 side by using the excitation source 6. A part of the primary light 4 applied to the first phosphor layer 1 is absorbed to the first phosphor, and excites the first phosphor. Then, the excited first phosphor emits the first fluorescence 41 upward and downward. Here, the optical filter 3 has a function to reflect the first fluorescence 41 though to allow passage of the primary light 4. Therefore, first fluorescence 41b emitted downward from the first phosphor is reflected by the surface 3a of the optical filter 3, and is emitted upward.

The primary light 4 that is not absorbed to the first phosphor layer 1 passes through the optical filter 3 and reaches the second phosphor layer 2. A part of the primary light 4 applied to the second phosphor layer 2 is absorbed to the second phosphor, and excites the second phosphor. Then, the excited second phosphor emits the second fluorescence 42 upward. Here, the optical filter 3 can allow passage of the second fluorescence 42, and accordingly, the second fluorescence 42 passes through the optical filter 3, and reaches the first phosphor layer 1. Note that the second fluorescence 42 that has reached the first phosphor layer 1 is not absorbed in the first phosphor, and passes through the first phosphor layer 1.

Note that a part of the primary light 4 is reflected by a surface 1a of the first phosphor layer 1, the surface 3a of the optical filter 3, and a surface 2a of the second phosphor layer 2, and is emitted upward.

Then, the first fluorescence 41a emitted upward from the first phosphor layer 1 and the first fluorescence 41b that is reflected by the optical filter 3 and has passed through the first phosphor layer 1, the second fluorescence 42 which has passed through the optical filter 3 and the first phosphor layer 1, and the primary light 4 are subjected to additive color mixture. As a result, the output light 5 in which these light components are mixed with one another is emitted to the outside of the light-emitting apparatus 100.

Here, in a case where the optical filter 3 is not provided between the first phosphor layer 1 and the second phosphor layer 2, the first fluorescence 41b emitted downward from the first phosphor layer 1 reaches the second phosphor layer 2. At least a part of the first fluorescence 41b that has reached the second phosphor is absorbed by the second phosphor, and accordingly, the color rendering properties of the obtained output light 5 decrease. However, in the light-emitting apparatus 100, the light component of the first fluorescence 41 is suppressed from being absorbed to the second phosphor by the function of the optical filter 3. Therefore, it becomes easy for the fluorescence spectrum shape of the first fluorescence 41 to keep the original shape thereof, thus making it possible to emit the output light 5 with high color rendering properties.

In the light-emitting apparatus 100, preferably, the first fluorescence 41 has a fluorescence peak within a wavelength range of 490 nm or more and less than 560 nm. Moreover, more preferably, the first fluorescence 41 has a fluorescence peak within a wavelength range of 500 nm or more and less than 550 nm, still more preferably, has a fluorescence peak within a wavelength range of 510 nm or more and less than 540 nm. Moreover, preferably, the second fluorescence 42 has a fluorescence peak within a wavelength range of 560 nm or more and less than 660 nm. Moreover, more preferably, the second fluorescence 42 has a fluorescence peak within a wavelength range of 580 nm or more and less than 650 nm, still more preferably, has a fluorescence peak within a wavelength range of 600 nm or more and less than 640 nm. In this case, a light-emitting apparatus can be obtained, which emits at least a green-series (blue-green or green) fluorescent component and a warm color-series (orange or red) fluorescent component, which are required for illumination with high color rendering properties.

In the light-emitting apparatus 100, preferably, at least one of the first phosphor and the second phosphor is a garnet phosphor having a garnet-type crystal structure. Moreover, more preferably, both of the first phosphor and the second phosphor are garnet phosphors having the garnet-type crystal structure. The garnet phosphors are easily producible, and have high track records for use in solid-state illumination, and accordingly, it becomes possible to obtain a light-emitting apparatus easy to manufacture and excellent in long-term reliability.

In the light-emitting apparatus 100, preferably, the first phosphor is a phosphor composed by containing, as a base material, at least one selected from the group consisting of Y₃Al₂(AlO₄)₃, Y₃Ga₂(AlO₄)₃, Lu₃Al₂(AlO₄)₃, and Lu₃Ga₂(AlO₄)₃. That is, preferably, the first phosphor is a garnet phosphor composed by containing, as a base material, any of these aluminate compounds. Such a Ce³⁺-activated garnet phosphor composed by containing, as a base material, the aluminate compound emits fluorescence including a large quantity of the blue-green or green light component that greatly contributes to the enhancement of the color rendering properties of the illumination light. Therefore, these garnet phosphors are used as the first phosphor, whereby a light-emitting apparatus can be obtained, which emits illumination light that has a relatively large quantity of the blue-green or green light component and is advantageous in terms of the color rendering properties. Moreover, the garnet phosphors have high track records for use in solid-state illumination, and accordingly, a light-emitting apparatus excellent in long-term reliability can be obtained.

Moreover, the Ce³⁺-activated garnet phosphor composed by containing, as a base material, such an aluminate compound includes a large quantity of blue-green to green light component having a substantially complementary-color relationship to orange to red. Therefore, this Ce³⁺-activated garnet phosphor is combined with a Ce³⁺-activated phosphor composed by containing, as a base material, Lu₂CaMg₂(SiO₄)₃, whereby a light-emitting apparatus can be formed, which is highly efficient and highly reliable, and is easy to obtain white-series light.

Here, "phosphor composed by containing, as a base material, at least one selected from the group consisting of Y₃Al₂(AlO₄)₃, Y₃Ga₂(AlO₄)₃, Lu₃Al₂(AlO₄)₃, and Lu₃Ga₂(AlO₄)₃" described above refers to a garnet phosphor containing any of the following (1) to (6) as a base material and including Ce³⁺ as a light emission center.
(1) Y₃Al₂(AlO₄)₃, Y₃Ga₂(AlO₄)₃, Lu₃Al₂(AlO₄)₃, or Lu₃Ga₂(AlO₄)₃, which is an aluminate compound
(2) Solid solution composed by containing, as end members, at least two types of garnet compounds selected from the above-described aluminate compounds
(3) Garnet compound that is a solid solution in which a solid solution ratio of any of the above-described aluminate compounds is 60 mol% or more, and particularly 80 mol% or more.
(4) Garnet compound that is not accompanied by charge compensation, the garnet compound having a composition deformed by substituting another element for a part of constituent elements of any of the above-described aluminate compounds
(5) Garnet compound that is accompanied by charge compensation, the garnet compound having a composition deformed by substituting another element for a part of constituent elements of any of the above-described aluminate compounds
(6) Solid solution composed by containing, as end members, at least two types of garnet compounds selected from the above-described (1) to (5)

Note that the first phosphor is not limited to the phosphors composed of the aluminate compounds. As the first phosphor, usable is a Ce³⁺-activated phosphor composed by containing, as a base material, a compound containing, as a main component, an alkaline earth metal composite oxide, alkaline earth metal halo-aluminate, rare earth aluminate, alkaline earth metal silicate, rare earth oxynitride alumino silicate, rare earth aluminonitride silicate, and rare earth oxynitride silicate, each of which has a calcium ferrite-type structure.

Specifically, as the first phosphor, usable is a Ce³⁺-activated phosphor composed by containing, as a base material, a compound selected from the group consisting of MRE₂O₄, M₃AlO₄F, M₂REX₂(AlO₄)₃, M₃RE₂(SiO₄)₃, REAl(Si_{6-z}Al_{z})(N_{10-z}O_{z}), RESi₃N₅, RE₅(SiO₄)₃N, RE₄Si₂O₇N₂, RESiO₂N, RE₂Si₃O₃N₄, RE₅Si₃O₁₂N, and RE₃Si₈O₄N₁₁. Moreover, as the first phosphor, a Ce³⁺-activated phosphor composed by containing, as a base material, a solid solution containing any of the above-mentioned compounds as an end member is usable. However, in the above-described compound, M is alkaline earth metal, RE is a rare earth element, X is at least one element selected from Zr and Hf, and z is a numeric value that satisfies 0 ≤ z < 1.

More specifically, as the first phosphor, for example, usable is a Ce³⁺-activated phosphor composed by containing, as a base material, any compound selected from the group consisting of SrLu₂O₄, SrSc₂O₄, Sr₃AlO₄F, Ca₂YZr₂(AlO₄)₃, Ca₃Sc₂(SiO₄)₃, LaAlSi₆N₁₀, LaSi₃N₅, Y₅(SiO₄)₃N, Y₄Si₂O₇N₂, Y₂Si₃O₃N₄, La₅Si₃O₁₂N, and La₃Si₈O₄N₁₁. Moreover, as the first phosphor, a Ce³⁺-activated phosphor composed by containing, as a base material, a solid solution containing any of the above-mentioned compounds as an end member is usable.

These phosphors can emit fluorescence having a peak within a wavelength range of 420 nm or more and less than 530 nm, and particularly 440 to 510 nm. Moreover, these phosphors can emit fluorescence including a large quantity of the blue-green light component. Therefore, a light-emitting apparatus can be obtained, which emits illumination light that has a relatively large quantity of the blue-green light component and is advantageous in terms of the color rendering properties.

In the light-emitting apparatus 100, preferably, the second phosphor is a phosphor composed by containing, as a base material, Lu₂CaMg₂(SiO₄)₃. That is, preferably, the second phosphor is a garnet phosphor composed by containing, as a base material, Lu₂CaMg₂(SiO₄)₃ that is a silicate compound. The Ce³⁺-activated garnet phosphor containing Lu₂CaMg₂(SiO₄)₃ as a base material emits orange light containing a large quantity of a red light component. Moreover, this Ce³⁺-activated garnet phosphor is a phosphor in which temperature quenching is relatively small. Therefore, such a garnet phosphor is used as the second phosphor, whereby a light-emitting apparatus can be obtained, which emits the output light 5 in which a quantity of the red light component essential for use in illumination is large, and has high efficiency and reliability.

Moreover, the Ce³⁺-garnet phosphor composed by containing Lu₂CaMg₂(SiO₄)₃ as a base material emits fluorescence containing a large quantity of an orange or red light component having a substantially complementary-color relationship to blue-green or green. Therefore, this Ce³⁺-activated garnet phosphor is combined with the first phosphor that emits blue-green or green light, whereby the white-series output light 5 can be obtained. Particularly, this Ce³⁺-activated garnet phosphor is combined with the Ce³⁺-activated phosphor composed by containing, as a base material, Y₃Al₂(AlO₄)₃, Y₃Ga₂(AlO₄)₃, Lu₃Al₂(AlO₄)₃, or Lu₃Ga₂(AlO₄)₃, whereby the white-series output light 5 is obtained.

Here, "phosphor composed by containing, as a base material, Lu₂CaMg₂(SiO₄)₃" described above refers to a garnet phosphor containing any of the following (1) to (5) as a base material and including Ce³⁺ as a light emission center.
(1) Lu2CaMg2(SiO4)3 that is a silicate compound
(2) Solid solution in which a solid solution ratio of Lu2CaMg2(Si04)3 is 60 mol% or more, and particularly 80 mol% or more
(3) Garnet compound that is not accompanied by charge compensation, the garnet compound having a composition deformed by substituting another element for a part of constituent elements of Lu₂CaMg₂(SiO₄)₃
(4) Garnet compound that is accompanied by charge compensation, the garnet compound having a composition deformed by substituting another element for a part of constituent elements of Lu₂CaMg₂(SiO₄)₃
(5) Solid solution composed by containing, as end members, at least two types of garnet compounds selected from the above-described (1) to (4)

In the light-emitting apparatus 100, preferably, the excitation source 6 emits the primary light 4, and the optical filter 3 allows passage of the primary light 4. Thus, the primary light 4 that has passed through the optical filter 3 can be used as excitation light of the first phosphor and the second phosphor. As a result, at least a part of the primary light 4 is subjected to wavelength conversion by the first phosphor, and is converted into the first fluorescence 41. Moreover, at least a part of the primary light 4 is subjected to wavelength conversion by the second phosphor, and is converted into the second fluorescence 42. Note that the primary light 4 that has passed through the optical filter 3 can also be used as a light component of the output light 5 emitted from the light-emitting apparatus 100.

In the light-emitting apparatus 100, preferably, the primary light 4 is blue light having a peak within a wavelength range of 420 nm or more and less than 470 nm. Moreover, more preferably, the primary light 4 is blue light having a peak within a wavelength range of 440 nm or more and less than 460 nm. Thus, the blue light that is short wavelength visible light can be used as the excitation light of the first phosphor and the second phosphor and as a part of the output light 5 of the light-emitting apparatus.

In the light-emitting apparatus 100, preferably, the primary light 4 is laser light. Thus, laser light that has a large light density and is excellent in directivity and convergence can be used as the excitation light of the first phosphor and the second phosphor and as the output light 5 of the light-emitting apparatus.

As mentioned above, the optical filter 3 is a member that allows passage of light in incident light, the light remaining within a specific wavelength range, and reflects or absorbs light remaining within the other wavelength range. Then, in the optical filter 3, preferably, a light transmittance within a wavelength range of 490 nm or more and less than 560 nm is smaller than a light transmittance within a wavelength range of 440 nm or more and less than 460 nm and a light transmittance within a wavelength range of 610 nm or more and less than 630 nm. That is, in the optical filter 3, preferably, a transmittance of the blue-green to green light with a wavelength of 490 nm or more and less than 560 nm is smaller than a transmittance of the blue light with a wavelength of 440 nm or more and less than 460 nm and a transmittance of the red light with a wavelength of 610 nm or more and less than 630 nm. Moreover, in the optical filter 3, more preferably, a transmittance of blue-green to green light with a wavelength of 500 nm or more and less than 550 nm is smaller than a transmittance of the blue light with a wavelength of 440 nm or more and less than 460 nm and a transmittance of the red light with a wavelength of 610 nm or more and less than 630 nm.

As described above, the optical filter 3 that allows easy passage of the blue and red light components and does not allow easy passage of the green light component is used, whereby a transmittance of a short wavelength side (blue to blue-green) light component in the green-series light can be relatively increased. Therefore, even if the second fluorescence emitted by the second phosphor is orange light inferior in red color purity, it becomes possible to obtain the output light 5 with high color rendering properties by using a blue light component of which quantity is relatively large. Moreover, such an optical filter as described above is used, whereby a transmittance of a short wavelength side (green to yellow) light component in the red-series light can be relatively reduced. Therefore, even if the second fluorescence emitted by the second phosphor is orange light inferior in red color purity, it becomes possible to obtain the output light 5 with high color rendering properties by using a light component of which red color purity is satisfactory.

In the optical filter 3, the transmittance of the blue light is preferably 30% or more, more preferably 50% or more. Moreover, in the optical filter 3, the transmittance of the red light is preferably 80% or more, more preferably 90% or more. In the optical filter 3, the transmittance of the blue-green to green light is preferably less than 30%, more preferably less than 10%, and particularly preferably less than 5%. Note that, in the optical filter 3, preferably, the transmittance of the blue light is lower than the transmittance of the red light. In a case where blue light of which spectrum half width is relatively narrow with respect to the fluorescent component of the phosphor, for example, blue laser light is used as the primary light 4, the optical filter 3 acts so as to suppress an output ratio of the blue light component. Therefore, it becomes possible to easily obtain the output light 5 with a low color temperature.

Here, in the optical filter 3, an upper limit of the transmittance is 100%, and a lower limit thereof is 0%. Therefore, the transmittance of each of the blue light, the red light, and the blue-green to green light is a numeric value within a range of 0% or more and 100% or less.

In the light-emitting apparatus 100, preferably, the optical filter 3 is a member consisting of an inorganic material. The optical filter 3 made of only an inorganic material is excellent in terms of heat resistance and durability, and accordingly, a light-emitting apparatus in which heat resistance and durability are improved can be obtained.

In the light-emitting apparatus 100, with regard to the optical filter 3, preferably, an integrated value of a transmittance of an light component with a wavelength of 600 nm or more and less than 660 nm is larger than an integrated value of a transmittance of a light component with a wavelength of 560 nm or more and less than 600 nm within a wavelength range of 560 nm or more and less than 660 nm. Thus, a color tone of the second fluorescence 42 that has already passed through the optical filter 3 becomes superior in color tone of red to a color tone of the second fluorescence 42 that has not passed through the optical filter 3 yet. That is, a red component is increased in the second fluorescence 42 that has already passed through the optical filter 3 more than in the second fluorescence 42 that has not passed through the optical filter 3 yet. Therefore, such output light 5 that emits a light component of red with a satisfactory color tone is formed, and accordingly, it becomes easy to obtain the output light 5 with high color rendering properties. That is, it becomes easy to obtain such output light 5 in which a numeric value of the special color rendering index R9 that is an index regarding chroma of red is high.

In the light-emitting apparatus 100, preferably, the optical filter 3 is an optical interference filter. The optical interference filter is composed by depositing a dielectric thin film on the surface of a substrate. Moreover, the dielectric thin film uses a phenomenon that light transmission characteristics change due to interference of reflection that occurs in an interface between air and a dielectric, between a dielectric and a substrate, and between dielectrics different from each other. Use of such an optical interference filter as described above makes it possible to relatively increase the transmittance of the light component of the second fluorescence 42 while decreasing the transmittance of the light component of the first fluorescence 41. Moreover, it is also easy to acquire the optical interference filter and to change a design thereof, and accordingly, it becomes possible to configure a desired light-emitting apparatus relatively easily.

Note that, in usual, the optical filter 3 has characteristics in which transmission characteristics change depending on an incident angle of incident light. Therefore, preferably, the primary light 4 emitted by the excitation source 6 enters an incident surface of the optical filter 3 perpendicularly or substantially perpendicularly. Moreover, also preferably, the second phosphor layer 2 is disposed at a place spaced apart from the optical filter 3. Thus, the primary light 4 and/or the second fluorescence 42 is suppressed from obliquely entering the incident surface of the optical filter 3. Therefore, it becomes possible to reflect the transmission characteristics of the optical filter 3 as they are on the output light 5. Note that "substantially perpendicular to the light incident surface of the optical filter 3" refers to a direction of 90°±10° with respect to the light incident surface, and more preferably, is a direction of 90°±5° with respect to the light incident surface.

In this embodiment, preferably, the light-emitting apparatus 100 emits the output light 5 including the primary light 4 emitted by the excitation source 6, the first fluorescence 41 emitted by the first phosphor, and the second fluorescence 42 emitted by the second phosphor. Thus, it becomes easy to obtain the output light 5 formed by the additive color mixture of the light component of the primary light 4, the light component of the first fluorescence 41, and the light component of the second fluorescence 42, and particularly, the white-series output light 5.

In the light-emitting apparatus 100, preferably, the output light 5 is white light in which a correlated color temperature is 2500 K or more and less than 8000 K, more preferably, is white light in which a correlated color temperature is 2800 K or more and 6700 K or less. Thus, it becomes easy to obtain such a light-emitting apparatus 100 that emits white light demanded much for illumination.

The average color rendering index Ra of the output light 5 preferably exceeds 80, and is more preferably 85 or more, particularly preferably 90 or more. Thus, it becomes possible to obtain such a light-emitting apparatus 100 that emits white light with high color rendering properties, which is demanded much for illumination.

Moreover, the special color rendering index R9 of the output light 5 preferably exceeds 30, and is more preferably 50 or more, particularly preferably 60 or more. Thus, it becomes possible to obtain such a light-emitting apparatus 100 that emits white light that is demanded much for illumination and emphasizes a red color of an object irradiated therewith.

A spectral distribution of the output light 5 can be formed to have a trace of the light transmission characteristics of the optical filter 3. Thus, such output light 5 that emits a red light component with a satisfactory color tone can be obtained.

In the light-emitting apparatus 100, preferably, the output light 5 is used as illumination light or display pixels. Thus, such a light-emitting apparatus usable as an illuminator or a display device can be obtained.

Preferable ones as specific examples of the light-emitting apparatus 100 are a semiconductor light-emitting apparatus, an illumination light source, an illuminator, a display device and the like, each of which is configured by using phosphors, and particularly, are laser illumination and a laser projector. Then, in the light-emitting apparatus 100, preferably, the excitation source 6 is a solid-state light emitting element that emits short wavelength visible light. Use of the solid-state light emitting element as the excitation source 6 make it possible to achieve an all-solid-state light-emitting apparatus resistant to impact, for example, solid-state illumination. Note that, particularly preferably, the solid-state light emitting element is a laser diode.

Note that, preferably, the light-emitting apparatus 100 is an apparatus for use in any of outdoor illumination, store illumination, a dimming system, facility illumination, ocean illumination, and an endoscope. Moreover, as a matter of course, the light-emitting apparatus 100 can be set to be a light-emitting apparatus that uses Internet of Things (IoT) or Artificial Intelligence (AI), of which technology has been remarkably developed in recent years.

As described above, the light-emitting apparatus 100 of this embodiment includes: the first phosphor layer 1 including the first phosphor composed of the inorganic phosphor activated by Ce³⁺; and the second phosphor layer 2 including the second phosphor composed of the inorganic phosphor activated by Ce³⁺ and different from the first phosphor. The second phosphor layer 2 is provided so as to be spaced apart from the first phosphor layer 1. The light-emitting apparatus 100 further includes: the optical filter 3 provided between the first phosphor layer 1 and the second phosphor layer 2; and the excitation source 6 that emits the light that excites at least one of the first phosphor and the second phosphor. The second phosphor has light absorption characteristics of absorbing at least a part of the first fluorescence 41 emitted by the first phosphor. The optical filter 3 reflects at least a part of the first fluorescence 41 emitted by the first phosphor, and allows passage of the second fluorescence 42 emitted by the second phosphor.

In the light-emitting apparatus 100, the optical filter 3 is interposed between the first phosphor layer 1 and the second phosphor layer 2. Therefore, it becomes difficult for the first fluorescence 41 emitted by the first phosphor layer 1 to be absorbed by the second phosphor layer 2, and accordingly, it becomes easy for the fluorescence spectrum shape of the first fluorescence 41 to keep the original shape thereof. As a result, even if the first phosphor layer 1 and the second phosphor layer 2, which are different in fluorescent color tone from each other, are brought close to each other, it becomes possible to emit the output light 5 with high color rendering properties.

### EXAMPLES

Hereinafter, this embodiment will be described more in detail by examples; however, this embodiment is not limited to these examples.

In the example, the transmissive-type light-emitting apparatus illustrated in FIG. 1 was fabricated. Note that a description of the reflective-type light-emitting apparatus illustrated in FIG. 2 was omitted since, from a principle point of view, it is obvious that similar functions and effects to those of the transmissive-type light-emitting apparatus are obtained thereby.

As the first phosphor that emits the first fluorescence, the Y₃Al₂(AlO₄)₃:Ce³⁺ phosphor was used. Note that a median particle diameter D₅₀ of the Y₃Al₂(AlO₄)₃:Ce³⁺ phosphor was 17 µm. Moreover, as the second phosphor that emits the second fluorescence, the Lu₂CaMg₂(SiO₄)₃:Ce³⁺ phosphor was used. Note that a median particle diameter D₅₀ of the Lu₂CaMg₂(SiO₄)₃:Ce³⁺ phosphor was 25 µm.

Note that, as the Y₃Al₂(AlO₄)₃:Ce³⁺ phosphor, a commercially available one was used, and as the Lu₂CaMg₂(SiO₄)3:Ce³⁺ phosphor, a self-made one was used. Specifically, the Lu₂CaMg₂(SiO₄)₃:Ce³⁺ phosphor was prepared by thermally reacting, at a temperature of 1300 to 1400 °C, mixed powder of a raw material of oxide ceramics and a compound functioning as a reaction accelerator.

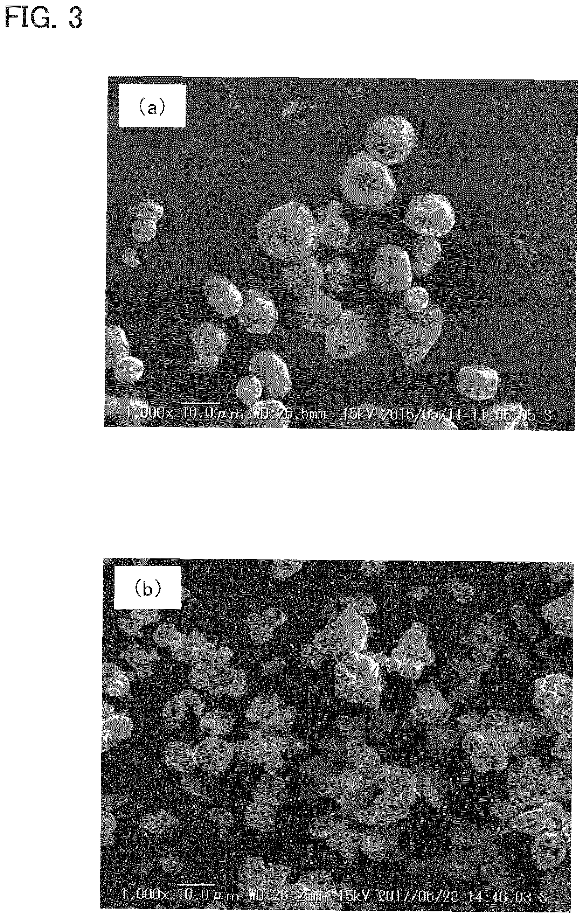

For reference, FIG. 3(a) shows an electron micrograph of the Y₃Al₂(AlO₄)₃:Ce³⁺ phosphor. FIG. 3(b) shows an electron micrograph of the Lu₂CaMg₂(SiO₄)₃:Ce³⁺ phosphor. Moreover, Table 1 collectively shows characteristics of these phosphors.

**[Table 1]**

| | | |
|---|---|---|
| Phosphor | Y₃Al₂(AlO₄)₃:Ce³⁺ | Lu₂CaMg₂(SiO₄)3:Ce³⁺ |
| Composition | (Y_{0.98}Ce_{0.02})₃Al₂(AlO₄)₃ 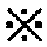 | (Lu_{0.97}Ce_{0.03})₂CaMg₂(SiO₄)₃ |
| Type | aluminate | silicate |
| Crystal structure | garnet type | garnet type |
| Average particle diameter | 10.5 µm | 6.4 µm |
| Fluorescence peak wavelength | 540 nm | 600 nm |
| Internal quantum efficiency at 455 nm | 96% | 82% |
| Light absorption rate at 455 nm | 80% | 67% |
| | | *Estimated composition |

Each of average particle diameters shown in Table 1 is set to an average value of major axis lengths of twenty particles which are recognizable as primary particles and arbitrarily extracted from each of electron microscope observation images shown in FIG. 3. Note that a magnification of such electron microscope observation images shown in FIG. 3 is 1000 times.

In this embodiment, as the first phosphor and the second phosphor, it is sufficient to prepare powdery phosphors having a particle diameter (1/16 mm to 1/256 mm) defined as silt defined in geology. Note that the phosphors do not need to be powdery, and may be phosphors of ceramic sintered bodies or single crystals.

As the excitation source, a blue laser diode (LD) was used. Moreover, as the primary light, blue laser light was used, which was emitted by the blue laser diode, and had a peak of 455 nm. Moreover, as the optical filter, an optical interference filter (part number: YIF-BA600IFS) made by SIGMAKOKI Co., Ltd. was used.

A light-emitting apparatus of this example includes: a Y₃Ab(AlO₄)₃:Ce³⁺ phosphor that emits the first fluorescence with a peak wavelength of 540 nm; and a Lu₂CaMg₂(SiO₄)₃:Ce³⁺ phosphor that emits the second fluorescence with a peak wavelength of 600 nm. Moreover, the light-emitting apparatus includes: the blue laser diode for exciting the Y₃Al₂(AlO₄)₃:Ce³⁺ phosphor and the Lu₂CaMg₂(SiO₄)3:Ce³⁺ phosphor; and the optical interference filter.

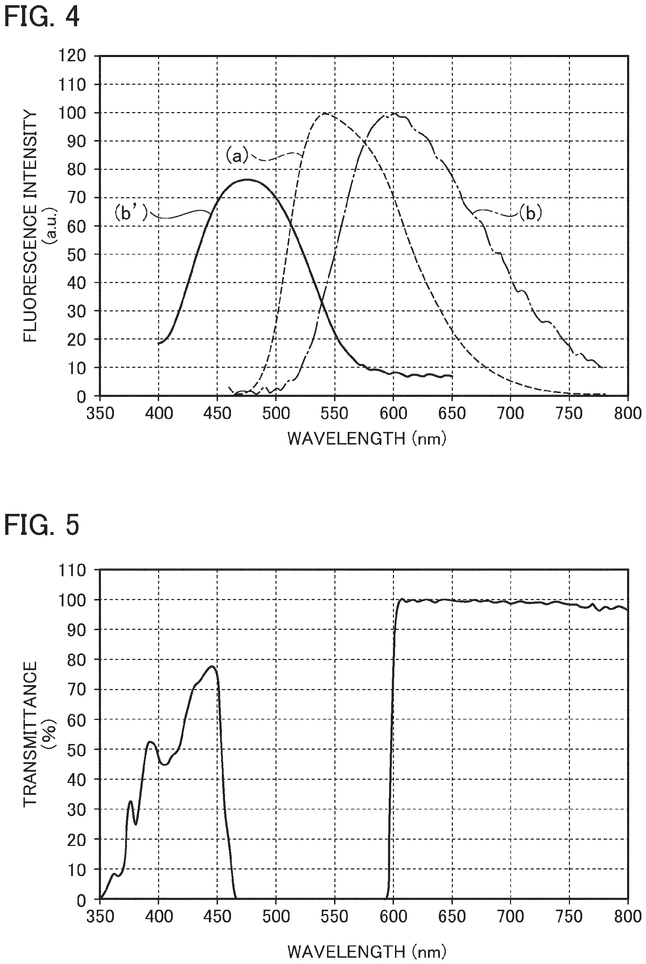

For reference, FIG. 4 illustrates a fluorescence spectrum of the Y₃Al₂(AlO₄)3:Ce³⁺ phosphor ((a) in FIG. 4) and a fluorescence spectrum of the Lu₂CaMg₂(SiO₄)₃:Ce³⁺ phosphor ((b) in FIG. 4). Moreover, in combination with the above, FIG. 4 illustrates wavelength dependency of a light absorption rate of the Lu₂CaMg₂(SiO₄)₃:Ce³⁺ phosphor, that is, an excitation spectrum of the Lu₂CaMg₂(SiO₄)₃:Ce³⁺ phosphor ((b') in FIG. 4). As seen from (a) and (b) in FIG. 4, the Y₃Al₂(AlO₄)₃:Ce³⁺ phosphor is a green phosphor that emits green light having a fluorescence peak at around 540 nm. Moreover, the Lu₂CaMg₂(SiO₄)₃:Ce³⁺ phosphor is an orange phosphor that emits orange light having a fluorescence peak at around 600 nm. That is, the Y₃Al₂(AlO₄)₃:Ce³⁺ phosphor and the Lu₂CaMg₂(SiO₄)₃:Ce³⁺ phosphor are phosphors different in fluorescent color tone from each other.

As seen from (a) and (b') in FIG. 4(a), the fluorescence spectrum of the Y₃Al₂(AlO₄)₃:Ce³⁺ phosphor partially overlaps the excitation spectrum of the Lu₂CaMg₂(SiO₄)₃:Ce³⁺ phosphor. That is, the Lu₂CaMg₂(SiO₄)₃:Ce³⁺ phosphor has light absorption characteristics of absorbing a part of fluorescence (first fluorescence) emitted by the Y₃Al₂(AlO₄)₃:Ce³⁺ phosphor.

Moreover, when (a) and (b') in FIG. 4 are compared with each other, a light component on a shorter wavelength side in the fluorescence spectrum of the Y₃Al₂(AlO₄)₃:Ce³⁺ phosphor has a larger overlap with the excitation spectrum of the Lu₂CaMg₂(SiO₄)₃:Ce³⁺ phosphor. That is, the Lu₂CaMg₂(SiO₄)3:Ce³⁺ phosphor has a property of satisfactorily absorbing such a short wavelength-side fluorescent component in the fluorescence spectrum of the Y₃Al₂(AlO₄)₃:Ce³⁺ phosphor. Therefore, when both of the phosphors are brought close to each other without using the optical filter, a part of the fluorescent component of the Y₃Al₂(AlO₄)₃:Ce³⁺ phosphor, and particularly the short wavelength-side fluorescent component will be absorbed by the Lu₂CaMg₂(SiO₄)3:Ce³⁺ phosphor.

Here, a fluorescent component of the Y₃Al₂(AlO₄)₃:Ce³⁺ phosphor, which is not absorbed to the Lu₂CaMg₂(SiO₄)3:Ce³⁺ phosphor, will be radiated as it is. Therefore, the fluorescent component emitted by the Y₃Al₂(AlO₄)₃:Ce³⁺ phosphor changes to one having a fluorescence spectrum in which an intensity of the blue-green light on the short wavelength side decreases. As a result, apparently, the fluorescence emitted by the Y₃Al₂(AlO₄)₃:Ce³⁺ phosphor becomes one in which a peak wavelength shifts to a long wavelength side. Note that this phenomenon will be referred to as "interference effect between phosphors" for convenience of explanation. As described above, the intensity of the blue-green to green light component inherent in the Y₃Al₂(AlO₄)₃:Ce³⁺ phosphor decreases, and the color rendering properties of the output light will be lowered.

FIG. 5 shows light transmission characteristics of the optical interference filter used in the example within a wavelength range of 350 nm or more and 800 nm or less. As seen from FIG. 5, in the optical interference filter, a transmittance within a wavelength range of 490 nm or more and less than 560 nm is significantly lower than a transmittance within a wavelength range of 440 nm or more and less than 460 nm and a transmittance within a wavelength range of 610 nm or more and less than 630 nm. That is, in the optical interference filter, a transmittance of the blue-green to green light is significantly lower than a transmittance of the blue light and a transmittance of the red light. For example, in the optical interference filter, the transmittance of the blue light within the wavelength range of 440 nm or more and less than 460 nm is 19% or more and less than 76%, which is higher than the transmittance of the blue-green to green light, and is lower than the transmittance of the red light. The transmittance of the blue-green to green light within the wavelength range of 490 nm or more and less than 560 nm is 0.005% or more and less than 0.5%, which is lower than the transmittance of each of the blue light and the red light. The transmittance of the red light within the wavelength range of 610 nm or more and less than 630 nm is 99% or more and less than 100%, which is higher than the transmittance of the blue to green light.

As described above, the optical interference filter of this example has a function to allow passage of the light components of the primary light (blue laser light) and the second fluorescence, and to make it difficult to allow the fluorescent component of the Y₃Al₂(AlO₄)₃:Ce³⁺ phosphor, and particularly, the fluorescent component of the blue-green to green wavelength.

Note that an integrated value of a transmittance of a light component within a wavelength range of 500 nm or more and less than 600 nm in the optical interference filter is almost zero particularly in a wavelength range of less than 595 nm. Therefore, without any calculation, it is seen that the integrated value of the transmittance of the light component within such a long wavelength range-side of 600 nm or more and less than 660 nm is larger than the integrated value of the transmittance of the light component with the wavelength of 500 nm or more and less than 600 nm.

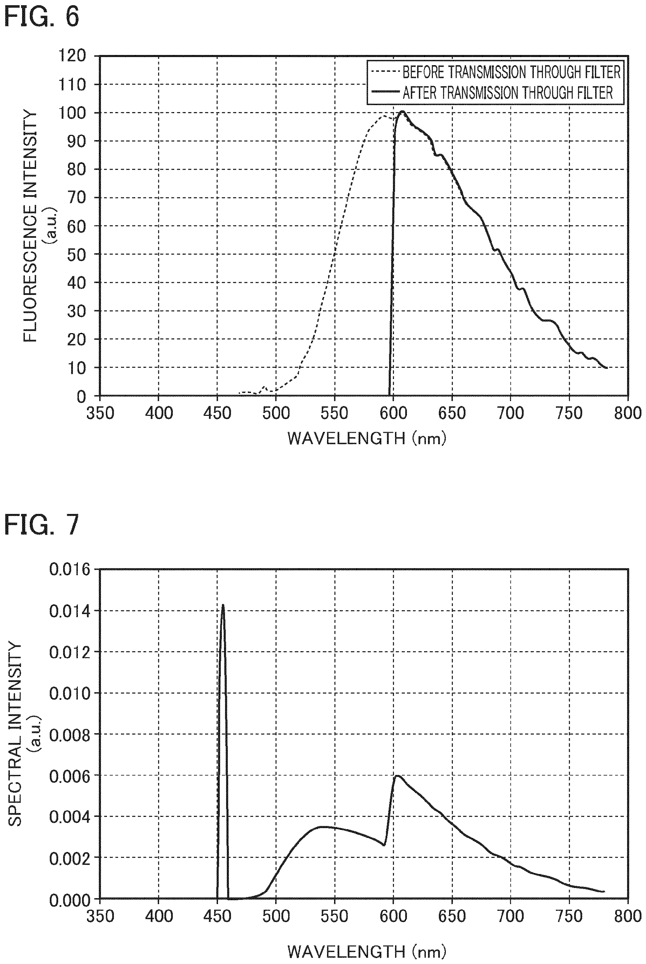

FIG. 6 illustrates, by a solid line, a spectral distribution of the fluorescence emitted from the Lu₂CaMg₂(SiO₄)₃:Ce³⁺ phosphor after the fluorescence passed through the optical interference filter. For reference, FIG. 6 also illustrates, by a dotted line, a spectral distribution of the fluorescence of the Lu₂CaMg₂(SiO₄)₃:Ce³⁺ phosphor before the fluorescence passes through the optical interference filter, that is, a fluorescence spectrum of the Lu₂CaMg₂(SiO₄)3:Ce³⁺ phosphor. As illustrated in FIG. 6, the fluorescence of the Lu₂CaMg₂(SiO₄)₃:Ce³⁺ phosphor passes through the optical interference filter, and thereby becomes light having a spectral distribution in which a fluorescent component in a green to yellow wavelength range less than 600 nm is cut off. As a result, by passing through the optical interference filter, the fluorescence of the Lu₂CaMg₂(SiO₄)₃:Ce³⁺ phosphor becomes a good one in the red color purity.

Here, as illustrated in FIG. 5, the transmittance of the optical interference filter within the wavelength range of 490 nm or more and less than 560 nm is substantially zero, and the optical interference filter reflects most of the blue-green to green light. Therefore, in a case where the optical interference filter is disposed between the Y₃Al₂(AlO₄)₃:Ce³⁺ and Lu₂CaMg₂(SiO₄)₃:Ce³⁺, almost all of the fluorescent component emitted by the Y₃Al₂(AlO₄)₃:Ce³⁺ is reflected by the optical interference filter. Then, the fluorescent component that reaches the Lu₂CaMg₂(SiO₄)₃:Ce³⁺ phosphor from the Y₃Al₂(AlO₄)₃:Ce³⁺ phosphor, and particularly, the blue-green to green fluorescent component becomes an ignorable one. As a result, it becomes possible to reduce the interference effect between the phosphors, and to suppress the decrease of the color rendering properties of the output light.

Moreover, as illustrated in FIG. 5, the optical interference filter allows passage of not a little quantity of the blue light within the wavelength range of 440 nm or more and less than 460 nm. Therefore, the output light emitted by the light-emitting apparatus of the example becomes light in which the blue laser light, the fluorescence of the Y₃Al₂(AlO₄)₃:Ce³⁺ phosphor, and the fluorescence of the Lu₂CaMg₂(SiO₄)3:Ce³⁺ phosphor, which has already passed through the optical interference filter, are subjected to the additive color mixture.

A spectral distribution of such light of the additive color mixture can be easily obtained now by simulation. Moreover, the spectral distribution in the simulation coincides with measured data relatively well. Therefore, white light, which is composed by combining these pieces of light and is located on the blackbody locus, was simulated.

FIG. 7 is an example of the simulation, and illustrates a spectral distribution of white output light with a correlated color temperature of 3000 K. The average color rendering index Ra obtained from the spectral distribution of FIG. 7 was 91.8, and the special color rendering index R9 obtained thereby was 68.7. That is, in accordance with this example, illumination light with high color rendering properties in which the average color rendering index Ra exceeds 90 can be obtained. Moreover, illumination light with high color rendering properties in which the special color rendering index R9 exceeds 60 can also be obtained.

Note that, as seen from FIG. 5 and FIG. 7, the spectral distribution of FIG. 7 is formed to have a trace of the light transmission characteristics which the optical interference filter of FIG. 5 has. Then, as a result, a spectral distribution in which an intensity in the yellow wavelength range was low and an intensity balance between blue, green, and red was achieved was formed, and light in which the average color rendering index Ra that was high and the special color rendering index R9 that was high were made compatible with each other was obtained.

Table 2 shows results of simulating white light with a correlated color temperature of 2500 K or more and 8000 K or less to calculate the color rendering indices similarly to the above.

**[Table 2]**

| Correlated color temperature | Ra | R9 |
|---|---|---|
| 2500 | 92.8 | 74.8 |
| 3000 | 91.8 | 68.7 |
| 3500 | 88.1 | 58.0 |
| 4000 | 84.6 | 45.9 |
| 4500 | 81.7 | 33.9 |
| 5000 | 79.1 | 21.1 |
| 5500 | 77.6 | 13.1 |
| 6000 | 76.1 | 5.4 |
| 6500 | 74.9 | -2.0 |
| 7000 | 73.8 | -8.8 |
| 7500 | 72.8 | -15.2 |
| 8000 | 71.9 | -21.0 |

As shown in Table 2, in cases of correlated color temperatures of 4500 K or less, average color rendering indices Ra exceeding 80 were obtained. In cases of correlated color temperatures of 3000 K or less, average color rendering indices Ra exceeding 90 were obtained. Moreover, in cases of correlated color temperatures of 6000 K or less, special color rendering indices R9 exceeding 0 were obtained. In cases of correlated color temperatures of 4500 K or less, special color rendering indices R9 exceeding 30 were obtained. Moreover, in cases of correlated color temperatures of 3500 K or less, special color rendering indices R9 exceeding 50 were obtained.

For reference, Table 3 shows results of simulations using the Y₃Ga₂(AlO₄)₃:Ce³⁺ phosphor in place of the Y₃Al₂(AlO₄)₃:Ce³⁺ phosphor of the example. Incidentally, a fluorescence peak wavelength of the Y₃Al₂(AlO₄)₃:Ce³⁺ phosphor was 540 nm, and a fluorescence peak wavelength of the Y₃Ga₂(AlO₄)₃:Ce³⁺ phosphor was 535 nm.

**[Table 3]**

| Correlated color temperature | Ra | R9 |
|---|---|---|
| 2500 | 85.2 | 92.6 |
| 3000 | 89.1 | 91.4 |
| 3500 | 92.3 | 94.8 |
| 4000 | 93.9 | 97.2 |
| 4500 | 94.2 | 91.7 |
| 5000 | 92.7 | 84.1 |
| 5500 | 91.7 | 80.2 |
| 6000 | 90.6 | 76.1 |
| 6500 | 89.5 | 71.8 |
| 7000 | 88.5 | 67.6 |
| 7500 | 87.6 | 63.6 |
| 8000 | 86.8 | 59.7 |

As shown in Table 3, in a case of any of correlated color temperatures of 2500 K or more and 8000 K or less, an average color rendering index Ra exceeding 85 was obtained. In cases of correlated color temperatures of 3500 K or more and less than 6500 K, average color rendering indices Ra exceeding 90 were obtained. Moreover, in a case of any correlated color temperatures, a special color rendering index R9 exceeding 60 was obtained. In cases of correlated color temperatures of 5500 K or more, special color rendering indices R9 exceeding 80 were obtained.

Moreover, for reference, Table 4 shows results of simulations using the Lu₃Al₂(AlO₄)₃:Ce³⁺ phosphor in place of the Y₃Al₂(AlO₄)₃:Ce³⁺ phosphor of the example. Incidentally, a fluorescence peak wavelength of the Y₃Al₂(AlO₄)₃:Ce³⁺ phosphor was 540 nm, and a fluorescence peak wavelength of the Lu₃Al₂(AlO₄)₃:Ce³⁺ phosphor was 518 nm.

**[Table 4]**

| Correlated color temperature | Ra | R9 |
|---|---|---|
| 2500 | 77.2 | 72.6 |
| 3000 | 80.7 | 65.3 |
| 3500 | 84.1 | 64.1 |
| 4000 | 87.1 | 65.9 |
| 4500 | 89.5 | 69.0 |
| 5000 | 90.7 | 73.5 |
| 5500 | 91.6 | 74.8 |
| 6000 | 92.2 | 76.8 |
| 6500 | 92.7 | 79.2 |
| 7000 | 93.0 | 81.7 |
| 7500 | 93.1 | 84.3 |
| 8000 | 93.2 | 86.8 |

As shown in Table 4, in cases of correlated color temperatures of 3000 K or more, average color rendering indices Ra exceeding 80 were obtained. In cases of correlated color temperatures of 5000 K or more, average color rendering indices Ra exceeding 90 were obtained. Moreover, in a case of any of correlated color temperatures, a special color rendering index R9 exceeding 60 was obtained. In cases of correlated color temperatures of 7000 K or less, special color rendering indices R9 exceeding 80 were obtained.

The following is seen. That is, as described above, in accordance with this example, the first phosphor is switched as appropriate to control the fluorescence spectrum and fluorescence peak wavelength of the first fluorescence, whereby the average color rendering index Ra and the special color rendering index R9 can be controlled. Then, it is seen that it is possible to achieve the illumination light with high color rendering properties in which the average color rendering index Ra of 90 or more and the special color rendering index R9 of 60 or more are made compatible with each other in a range of at least 2500 K or more and 8000 K or less.

Although this embodiment has been described above by the examples, this embodiment is not limited to these, and various modifications are possible within the scope of the spirit of this embodiment.

The entire contents of Japanese Patent Application No. 2017-241754 (filed on: December 18, 2017) are incorporated herein by reference.

### INDUSTRIAL APPLICABILITY

In accordance with the present disclosure, there can be provided the light-emitting apparatus capable of emitting output light with high color rendering properties even if a plurality of types of Ce³⁺-activated phosphors different in color tone are brought close to each other.

### REFERENCE SIGNS LIST

- 1: First phosphor layer
- 2: Second phosphor layer
- 3: Optical filter
- 4: Primary light
- 5: Output light
- 6: Excitation source
- 41, 41a, 41b: First fluorescence
- 42: Second fluorescence
- 100: Light-emitting apparatus

## Claims

1. A light-emitting apparatus comprising:
a first phosphor layer including a first phosphor composed of an inorganic phosphor activated by Ce³⁺;
a second phosphor layer including a second phosphor composed of an inorganic phosphor activated by Ce³⁺ and different from the first phosphor, the second phosphor layer being provided so as to be spaced apart from the first phosphor layer;
an optical filter provided between the first phosphor layer and the second phosphor layer; and
an excitation source that emits light that excites at least one of the first phosphor and the second phosphor,
wherein the second phosphor has light absorption characteristics of absorbing at least a part of first fluorescence emitted by the first phosphor, and
the optical filter reflects at least a part of the first fluorescence emitted by the first phosphor, and allows passage of second fluorescence emitted by the second phosphor.

2. The light-emitting apparatus according to claim 1,
wherein the first fluorescence has a fluorescence peak within a wavelength range of 490 nm or more and less than 560 nm, and
wherein the second fluorescence has a fluorescence peak within a wavelength range of 560 nm or more and less than 660 nm.

3. The light-emitting apparatus according to claim 1 or 2, wherein at least one of the first phosphor and the second phosphor is a garnet phosphor having a garnet-type crystal structure.

4. The light-emitting apparatus according to any one of claims 1 to 3, wherein the first phosphor is a phosphor composed by containing, as a base material, at least one selected from the group consisting of Y₃Al₂(AlO₄)₃, Y₃Ga₂(AlO₄)₃, Lu₃Al₂(AlO₄)₃, and Lu₃Ga₂(AlO₄)₃.

5. The light-emitting apparatus according to any one of claims 1 to 4, wherein the second phosphor is a phosphor composed by containing, as a base material, Lu₂CaMg₂(SiO₄)₃.

6. The light-emitting apparatus according to any one of claims 1 to 5, wherein the excitation source emits primary light, and the optical filter allows passage of the primary light.

7. The light-emitting apparatus according to claim 6, wherein the primary light is blue light having a peak within a wavelength range of 420 nm or more and less than 470 nm.

8. The light-emitting apparatus according to claim 6 or 7, wherein the primary light is laser light.

9. The light-emitting apparatus according to any one of claims 1 to 8, wherein, in the optical filter, a light transmittance within a wavelength range of 490 nm or more and less than 560 nm is smaller than a light transmittance within a wavelength range of 440 nm or more and less than 460 nm and a light transmittance within a wavelength range of 610 nm or more and less than 630 nm.

10. The light-emitting apparatus according to any one of claims 1 to 9, wherein the optical filter is a member consisting of an inorganic material.

11. The light-emitting apparatus according to any one of claims 1 to 10, wherein a red component is increased in the second fluorescence that has already passed through the optical filter more than in the second fluorescence that has not passed through the optical filter yet.

12. The light-emitting apparatus according to any one of claims 1 to 11, wherein the light-emitting apparatus emits output light including the primary light emitted by the excitation source, the first fluorescence emitted by the first phosphor, and the second fluorescence emitted by the second phosphor.

13. The light-emitting apparatus according to claim 12, wherein the output light is white light in which a correlated color temperature is 2500 K or more and less than 8000 K.

14. The light-emitting apparatus according to claim 12 or 13, wherein an average color rendering index Ra of the output light exceeds 80.

15. The light-emitting apparatus according to any one of claims 12 to 14, wherein a special color rendering index R9 of the output light exceeds 30.

16. The light-emitting apparatus according to any one of claims 12 to 15, wherein the output light is used as illumination light or display pixels.
